# EUROPÄISCHE PATENTANMELDUNG

(11) **EP 3 506 508 A1**
(43) Veröffentlichungstag der Anmeldung: **03.07.2019**
(21) Anmeldenummer: 18214276.0
(22) Anmeldetag: 19.12.2018
(51) Int. Cl.: H03K 17/687

(54) **BIDIREKTIONALER ELEKTRONISCHER SCHALTER**

(30) Priorität: 29.12.2017 DE 102017012069
(71) Anmelder: Kliem, Thomas, 78628 Rottweil (DE)
(72) Erfinder: Kliem, Thomas, 78628 Rottweil (DE)
(74) Vertreter: Düsselberg, David

(57) **Zusammenfassung**

Die Erfindung betrifft eine elektronische Schaltungsanordnung, insbesondere ein Halbleiterrelais, zur bidirektionalen elektronischen Leistungsschaltung, welche an einen Verbraucher (V) und an eine elektrische Spannungsquelle (UBATT) anschließbar ist, aufweisend zwei Feldeffekttransistoren (T1, T2) und eine Steuerungsschaltung (L1), wobei die Steuerungsschaltung mit dem jeweiligen Gateanschluss der Feldeffekttransistoren leitungstechnisch verbunden ist, wobei die Feldeffekttransistoren anti-seriell geschaltet sind. Ferner betrifft die Erfindung die Verwendung einer erfindungsgemäßen elektronischen Schaltungsanordnung.

## Beschreibung

Die Erfindung betrifft eine elektronische Schaltungsanordnung, insbesondere ein Halbleiterrelais, zur bidirektionalen elektronischen Leistungsschaltung.

Im bekannten Stand der Technik wurden zum Schalten von Verbrauchern, beispielsweise in Industrieanlagen oder Kraftfahrzeugen, elektromagnetische Relais eingesetzt, um eine Last, beispielsweise eine induktive oder eine kapazitive Last, leistungsarm zu schalten. Elektromagnetische Relais haben jedoch den Nachteil, dass sie viel Bauraum benötigen und relativ langsam schalten. Außerdem nehmen sie verhältnismäßig viel elektrische Leistung auf und sind störanfällig.

Es wurde daher versucht, zur Vermeidung dieser Nachteile elektronische Schalter, insbesondere Transistoren für Relais zu verwenden, um die Schaltzeit zu verkürzen und um die Stromaufnahme zu reduzieren. Dies sind die sogenannten Halbleiterrelais. Allerdings haben bekannte Halbleiterrelais gegenüber elektromechanischen Relais den Nachteil, dass sie den Strom im Ausgangskreis nur in eine Richtung schalten können, Ein- und Ausgangskreis gegenüber Überlast und Störimpulsen anfällig sind und höhere Spannungsabfälle im Ausgangskreis aufweisen.

Durch den Umstand, das bekannte Halbleiterrelais nur unidirektional schalten können, ist es nicht möglich sie gegen Masse zu schalten und zu trennen. Vielmehr besteht hierbei die Gefahr, dass der Transistor zerstört wird. Auch eine unsachgemäße Verpolung kann insbesondere bei vergleichsweise hohen Strömen zur Beschädigung oder zur Zerstörung des Transistors führen.

Es besteht daher ein vitales Interesse daran, Halbleiterrelais zu entwickeln, die hinsichtlich ihrer positiven Eigenschaften elektromechanischen Relais nachgebildet sind. Dies war bisher nicht möglich. In einer Vielzahl von Anwendungen können elektromechanische Relais daher nicht ohne weiteres ersetzt werden.

Aus dem Stand der Technik sind in diesem Zusammenhang klassische Hochleistungsschalter wie Thyristoren bzw. Triacs bekannt, die bidirektional schaltbar sind. Sie haben jedoch den Nachteil, dass sie sich nicht über das Gate abschalten lassen. Erst bei Polaritätswechsel der Netzspannung werden sie wieder hochohmig und können neugezündet werden. Neuere abschaltbare Technologien wie GTOs bzw. IGCTs sind aufgrund der Bauform und der vergleichsweise hohen Kosten für eine Vielzahl von Anwendungen nicht praktikabel.

Es ist daher die **Aufgabe** der Erfindung, eine elektronische Schaltungsanordnung, insbesondere ein Halbleiterrelais, anzugeben, welches vergleichsweise hohe Ströme bidirektional schalten kann.

Zur **Lösung** der Aufgabe schlägt die Erfindung eine elektronische Schaltungsanordnung, insbesondere ein Halbleiterrelais, zur bidirektionalen elektronischen Leistungsschaltung, welche an einen Verbraucher und an eine elektrische Spannungsquelle anschließbar ist vor, aufweisend zwei Feldeffekttransistoren und eine Steuerungsschaltung, wobei die Steuerungsschaltung mit dem jeweiligen Gateanschluss der Feldeffekttransistoren leitungstechnisch verbunden ist, wobei die Feldeffekttransistoren anti-seriell geschaltet sind.

Anti-seriell bezeichnet im Sinne der Erfindung eine Reihenschaltung der Feldeffekttransistoren (FETs) in entgegengesetzter Polung. Dies bedeutet, dass beispielsweise der Sourceanschluss des ersten Feldeffekttransistors mit dem Sourceanschluss des zweiten Feldeffekttransistors leitungstechnisch verbunden ist. Ferner ist es möglich, dass der Drainanschluss des ersten Feldeffekttransistors mit dem Drainanschluss des zweiten Feldeffekttransistors leistungstechnisch verbunden ist. Leitungstechnisch im Sinne der Erfindung bezeichnet eine elektrisch leitende Verbindung.

Durch die erfindungsgemäße Schaltungsanordnung ist es erstmals möglich, elektrischen Gleichstrom mit hoher Stromstärke bestimmungsgemäß bidirektional zu schalten. Hierdurch kann ein Verbraucher sowohl in Masseschaltung als auch in Plusschaltung betrieben werden. Die Schaltungsanordnung ist dabei vollständig verpolungssicher. Verpolungssicher im Sinne der Erfindung bezeichnet dabei den Umstand, dass die erfindungsgemäße Schaltungsanordnung unabhängig davon funktionstüchtig ist mit welchem Pol der elektrischen Spannungsquelle die entsprechenden Anschlüsse der Schaltungsanordnung leitungstechnisch verbunden werden.

Grundsätzlich sind erfindungsgemäß alle Arten von Feldeffekttransistoren einsetzbar. Zu den bevorzugten Feldeffekttransistoren gehören die Isolierschichtfeldeffekttransistoren.

Bei einem Isolierschichtfeldeffekttransistor (IGFET) trennt eine elektrisch nichtleitende Schicht die Steuerelektrode (*gate*) vom sogenannten Kanal, dem eigentlichen Halbleitergebiet in dem später der Transistorstrom zwischen Source und Drain fließt. Der übliche Aufbau eines solchen Transistors besteht aus einer Steuerelektrode aus Metall, einer elektrisch isolierenden Zwischenschicht und dem Halbleiter, also einer Metall-Isolator-Halbleiter-Struktur. Transistoren des Aufbaus werden daher Metall-Isolator-Halbleiter-(MISFET) oder - wenn ein Oxid als Nichtleiter eingesetzt wird - Metall-Oxid-Halbleiter-Feldeffekttransistor (MOSFET) genannt.

Der Stromfluss im Kanal wird dabei über das elektrische Potential am Gate gesteuert, genauer der Spannung zwischen Gate und Body. Die Verwendung von IGFETs ist besonders bevorzugt. Vorzugsweise ist der Body dabei intern mit der Source verbunden. Die Steuerung erfolgt in diesem Fall über die Spannung zwischen Gate und Source. Vorzugsweise weist das IGFET eine Bodydiode auf. Durch die Bodydiode sind IGFETs grundsätzlich bidirektional. Hierdurch ist es mittels eines einzigen IGFETs nicht möglich, in beide Stromrichtungen zu sperren. Erst durch die erfindungsgemäße anti-serielle Anordnung der Transistoren wird ein bidirektionales Relais geschaffen. sind beide Transistoren geschlossen, ist der Stromfluss in beide Stromrichtungen gesperrt. Sind sie hingegen beide geöffnet, kann Strom bidirektional über den jeweiligen Source-Drain Kanal fließen.

Prinzipiell können auch JFETs eingesetzt werden. Diese haben den Vorteil, dass sie keine Bodydiode besitzen. Sie sind daher in beide Richtungen sperrend.

Erfindungsgemäß können n-Kanal FETs und/oder p-Kanal FETs eingesetzt werden. Beide Arten können dabei vom Anreicherungstyp oder vom Verarmungstyp sein. Vorzugsweise sind die n-Kanal FETs und/oder die p-Kanal FETs dabei vom Anreicherungstyp. Der Anreicherungstyp ist selbstsperrend. Das bedeutet, dass die Gate-Source Spannung (Steuerungsspannung) zunächst eine Schwellenspannung überschreiten muss, damit ein leitender Kanal ausgebildet wird. Es wird kein leitender Kanal auf der Source-Drain Strecke gebildet, wenn keine Ansteuerung des Gates erfolgt. Hierdurch ist sichergestellt, dass beispielsweise bei einem Defekt in der Steuerungsschaltung des Gates der Stromfluss unterbrochen wird. Die Schwellenspannung bei selbstsperrenden p-Kanal IGFETs ist dabei <0 V. Wenn nun der Ausgang gegen Masse geschaltet wird, kann diese Spannungsdifferenz nicht mehr durch den Bezug Gate / Source erzeugt werden. Der IGFET der als Low-Side-Treiber geschaltet wird würde sperren. Zur Ansteuerung ist daher eine negative Spannung erforderlich. Negative Spannung bezeichnet im Sinne der Erfindung eine Spannung, die kleiner ist als das Bezugspotential. Das Bezugspotential ist vorzugsweise durch eine interne Masse bereitgestellt. Dem Bezugspotential ist vorzugsweise der Wert 0 zugeordnet. Hierzu weist die Steuerungsschaltung vorzugsweise einen Negativspannungsregler auf. Bevorzugt sind selbstsperrende p-Kanal IGFETs. Diese haben den Vorteil, dass sie durch Wegschalten oder Zuschalten der Masse ein- und ausgeschaltet werden können. Ferner sind p-Kanal IGFETs mit einer betragsmäßig vergleichsweise geringen negativen Steuerungsspannung steuerbar.

Alternativ kann die erfindungsgemäße Schaltungsanordnung auch mittels selbstsperrender n-Kanal IGFETs realisiert werden. Dies ist insbesondere in dem Fall bevorzugt, in dem die anliegende Versorgungsspannung 50 V überschreitet. Es ist hierbei bevorzugt, dass die Steuerungsschaltung wenigstens eine Ladungspumpe aufweist. Hierdurch ist eine effektive Ansteuerung des Gates sichergestellt. Dies insbesondere deshalb, da die Steuerungsspannung die Versorgungsspannung übersteigen muss, um eine Steuerung des Gates zu bewirken und einen n-Kanal auszubilden.

Erfindungsgemäß sind Feldeffekttransistoren anti-seriell geschaltet. Dies bedeutet, dass beispielsweise der Sourceanschluss des ersten Feldeffekttransistors mit dem Sourceanschluss des zweiten Feldeffekttransistors leitungstechnisch verbunden ist. Ferner ist es möglich, dass der Drainanschluss des ersten Feldeffekttransistors mit dem Drainanschluss des zweiten Feldeffekttransistors leistungstechnisch verbunden ist. Die Wahl der Anordnung ist dabei abhängig von der Wahl der FETs. Sind die FETs als selbstsperrende p-Kanal IGFETs ausgebildet, ist eine Source-Source Verbindung bevorzugt. Sind die FETs hingegen als n-Kanal IGFETs ausgebildet ist eine Drain-Drain Verbindung bevorzugt. Hierbei wird jeweils die natürliche Ausbildungsrichtung des jeweiligen p- oder n-Kanals ausgenutzt.

Im Falle einer Source-Source Verbindung der p-Kanal IGFETs ist jede der beiden IGFETs jeweils in Sperrrichtung der Bodydiode des jeweils anderen IGFETs angeordnet. In dem Fall, dass beide IGFETs geschlossen sind und sich im "Off"-Zustand befinden, kann Strom je nach Polung über die Bodydiode des einen IGFETs fließen, nicht jedoch über den zweiten IGFET, der in Sperrrichtung seiner Bodydiode geschaltet ist. Auf diesem Weg ist ein bidirektionaler Schalter realisiert. Wird nun ein IGFET angesteuert, so fließt ein Strom über die Bodydiode des ersten IGFETs in Durchlassrichtung und über den p-Kanal des zweiten IGFETs. Im Falle einer Drain-Drain Verbindung ist die Reihenfolge umgekehrt. Hierdurch ist mit vergleichsweise wenigen elektronischen Bauelementen ein bidirektionales Halbleiterrelais realisierbar.

Gemäß einer bevorzugten Ausgestaltung sind die beiden FETs jeweils mit einer Diode parallel geschaltet. Obwohl der Betrieb über die Bodydiode dem Grunde nach praktikabel ist, birgt dieses Konzept den Nachteil, dass durch die Bodydiode eine höhere Verlustleistung entstehen kann. Ferner besteht insbesondere bei höheren Stromstärken die Gefahr, dass die Bodydiode und/oder der FET insgesamt nicht überlastet und dadurch zerstört wird. Durch die Parallelschaltung jeweils einer zusätzlichen Diode wird der Strom bei entsprechender Polung an der in Durchlassrichtung angeordneten Bodydiode des einen FETs vorbeigeführt. Es ist bevorzugt, dass die beiden Dioden ebenfalls anti-seriell geschaltet sind. Es ist dabei ferner bevorzugt, dass die jeweilige Diode derart geschaltet ist, dass deren jeweilige Durchlass- und Sperrrichtung derjenigen der Bodydiode des parallel geschalteten FETs entspricht. Hierdurch ist ein verbessertes Halbleiterrelais realisiert.

Gemäß einem bevorzugten Merkmale der Erfindung bildet die erfindungsgemäße Schaltungsanordnung eine Baugruppe eines Halbleiterrelais. Das Halbleiterrelais verfügt vorzugsweise über elektrische Anschlüsse, insbesondere in Form von Klemmen, mit denen die Baugruppe mit einer Versorgungsspannung verbunden werden kann. Es ist dabei prinzipiell möglich, die Steuerungsspannung im Falle von p-Kanal IGFETs insbesondere eine negative Steuerungsspannung zwischen - 5 V und -10 V bezogen auf das interne Bezugspotential, aus einer separaten, von der Versorgungsspannungsquelle unabhängigen Spannungsquelle zu entnehmen. Bevorzugt ist es jedoch, die Steuerungsspannung ebenfalls aus der Versorgungsspannungsquelle zu entnehmen.

Gemäß einer bevorzugten Weiterbildung der Erfindung weist die erfindungsgemäße Steuerungsschaltung hierzu einen Gleichrichter auf. Vorzugsweise ist der Gleichrichter über einen Eingangsschalter an den positiven Pol der Versorgungsspannungsquelle und/oder über einen Schalter, insbesondere einen Schutzschalter, an den negativen Pol der Versorgungsspannungsquelle leitungstechnisch anschließbar. Hierdurch benötigt die erfindungsgemäße Schaltungsanordnung einen wesentlich geringeren Betriebsstrom als elektromechanische Relais. Wenn die Versorgungsspannung von einer Batterie geliefert wird, erhöht sich dadurch die Entladungszeit der Batterie erheblich. Wenn das Halbleiterrelais gemäß der Erfindung als Batterietrennrelais verwendet wird, bleibt die Batterie permanent eingeschaltet.

Bei Einsatz von elektromechanischen Relais hat das zur Folge gehabt, dass die Batterie eines Fahrzeugs schon nach kurzer Zeit entladen war. Dies stellte vor allem bei Lastkraftwagen oder Bussen ein großes Problem dar, weil deren Batterien nach kurzer Stillstandzeit nicht mehr einsatzfähig waren. Ferner sind durch diese bevorzugte Ausgestaltung in vorteilhafter Weise sowohl der Versorgungsstromkreis als auch der Steuerungsstromkreis bidirektional ausgebildet.

Das hierdurch realisierte Halbleiterrelais kann folglich ohne Gefahr einer Beschädigung oder eine Folgedefekts durch Aus- oder Einschalten des Eingangsschalters in Plusschaltung und/oder durch Weg- oder Zuschalten der Masse bedient werden. Ferner ist es gegenüber einer Verpolung im Sinne einer Falschpolung vollkommen unempfindlich und kann auch mit entgegengesetzter Polung betrieben werden. Es ist daher möglich, einen Verbraucher in Plusschaltung oder Masseschaltung in der jeweils gewünschten Polung zu betreiben.

Gemäß einer bevorzugten Ausgestaltung der Erfindung weist der Gleichrichter einen Überspannungsschutz auf. Vorzugsweise ist der Überspannungsschutz als Varistor ausgebildet. Dabei handelt es sich um einen spannungsabhängigen Widerstand, dessen elektrischer Widerstand bei konstanter Temperatur mit zunehmender Spannung stark abnimmt. Alternativ kann der Überspannungsschutz als Suppressordiode ausgebildet sein.

Gemäß einer bevorzugten Ausgestaltung der Erfindung weist die Steuerschaltung eine Ansteuerelektronik auf. Vorzugsweise ist die Ansteuerelektronik zwischen Gleichrichter und den Gates der FETs in Reihe geschaltet. Der Grund hierfür ist, dass insbesondere ein n-Kanal IGFET eine hohe Ansteuerspannung von wenigstens 10 Volt am Gate benötigt. Bei einer diesen Grenzwert unterschreitenden Spannung geht der Feldeffekttransistor in den Analogbetrieb über, was die Gefahr einer Überlastung mit sich bringt. Um das zu verhindern, ist die Ansteuerelektronik vorgesehen, die als Unterspannungsschutz die Baugruppe mit dem FET zwangsweise abschaltet. Vorzugsweise weist die Ansteuerelektronik ein Verzögerungselement auf. Hierdurch kann insbesondere die Aufladungszeit der Spule eines elektromechanischen Relais nachgebildet werden. Vorzugsweise ist das Verzögerungselement als Hystereseschaltung ausgebildet. Besonders bevorzugt ist die Hystereseschaltung durch einen Schmitt-Trigger gebildet. Hierdurch können mit Bezug auf die Spannung diskrete Schaltschwellen vorgegeben werden. Bevorzugt liegen die Schaltschwellen bei einer Nennspannung von 12V bei >9V (Ein) und bei <2V (Aus). Bei einer Nennspannung von 24V bei liegen die Schaltschwellen bei >18V (Ein) und bei <3V (Aus). Da die Schwellen nicht proportional zur Versorgungsspannung sind, erbringt der Schmitt-Trigger den Vorteil, eine hiervon unabhängige Einstellung der Schaltschwellen vornehmen zu können.

Die Verzögerung ist darüber hinaus bevorzugt, damit, sofern die Steuerungsspannung aus der Versorgungsspannung entnommen wird, die Ladungspumpe oder der Negativspannungsregler genug Zeit haben um die Spannung aufzubauen. Ansonsten besteht die Möglichkeit, dass die FETs zu lange im unerwünschten Analogbetrieb betrieben werden.

Gemäß einem bevorzugten Merkmal der Erfindung ist die gesamte Baugruppe in einem Gehäuse aus einer wärmeleitenden Vergussmasse eingebettet, die die Wärmeableitung der Halbleiterelemente zur Gehäusewand unterstützt.

Das Gehäuse kann eine rechteckige Bodenplatte mit Steckkontaktelementen aufweisen, die vertauschungssicher und kompatibel mit genormten Steckrelais elektromagnetischer Bauweise sind. Damit kann ein elektromagnetisches Relais problemlos gegen ein Halbleiterrelais gemäß der Erfindung ausgetauscht werden.

Um den Innenwiderstand der Feldeffekttransistoren zur reduzieren und dadurch die Verlustleistung bei den elektronischen Bauteilen möglichst gering zu halten, können mehrere Feldeffekttransistoren in dem Halbleiterrelais parallel geschaltet werden, beispielsweise bis zu fünf FET. Dies hat außerdem den Vorteil, dass die Leistung des Halbleiterrelais an hohe Stromstärken angepasst werden kann. Durch die bevorzugte Parallelschaltung wird die bidirektionale Schaltung von Strom mit Stromstärken oberhalb von 70 A möglich.

Gemäß einem weiteren Merkmal der Erfindung verfügen die FETs über einen Überspannungsschutz. Dieser ist vorzugsweise durch eine Suppressordiode gebildet, die parallel zu den anti-seriell geschalteten FETs geschaltet ist. Alternativ kann der Überspannungsschutz auch durch einen Varistor oder ein ähnliches Bauteil realisiert sein.

Gemäß einem weiteren Merkmal der Erfindung verfügen die Gateanschlüsse über einen Überspannungsschutz. Insbesondere bei p-Kanale IGFETs liegen am Gate Steuerungsspannung und Versorgungsspannung an. Hierdurch kann die maximal zulässige Gatespannung überschritten werden. Der Überspannungsschutz ist durch eine Diode realisiert, die die Spannung im Falle einer Überspannung begrenzt. Vorzugsweise ist die Diode als Z-Diode ausgebildet.

Die Erfindung betrifft ferner die Verwendung einer erfindungsgemäßen elektronischen Schaltungsanordnung, insbesondere eines Halbleiterrelais, insbesondere in einem Kraftfahrzeug, insbesondere zur bidirektionalen Schaltung von elektrischem Gleichstrom mit einer Stromstärke von 1 A bis 1000 A, vorzugsweise von 40 A bis 1000 A, bevorzugt 70 A bis 1000 A, besonders bevorzugt 70 bis 500 A.

Gemäß einem bevorzugten Merkmal der Erfindung ist die Steuerungsschaltung galvanisch von den Gateanschlüssen der Feldeffekttransistoren getrennt. Hierzu ist vorzugsweise eine entsprechende Trenneinrichtung zwischen Ladungspumpe oder Negativspannungsregler einerseits und dem gemeinsamen Gateanschluss angeordnet. "Galvanische Trennung" meint in diesem Zusammenhang das Vermeiden der elektrischen Leitung zwischen zwei Stromkreisen, zwischen denen Leistung oder Signale ausgetauscht werden sollen. Die elektrische Leitung wird dabei durch elektrisch nicht leitfähige Kopplungsglieder aufgetrennt. Bei galvanischer Trennung sind die elektrischen Potentiale voneinander getrennt und die Stromkreise sind dann untereinander potentialfrei. Dies ist insbesondere in dem Fall von Vorteil, in dem die Steuerungsspannung negativ ist. Dies deshalb, da sich die Versorgungs- und Steuerungsstromkreis vorzugsweise in einem gemeinsamen Gehäuse befinden und zumindest einer auf den anderen einwirken soll. Gleichwohl müssen sie dabei aber in ihren Bezugspotentialen getrennt bleiben. Dies ist durch die bevorzugte galvanische Trennung erreicht. Die Trennung kann dabei mittels Transformatoren (induktiv), mittels Kondensatoren (kapazitiv) oder mittels Relais oder Optokopplern erfolgen.

Die Erfindung betrifft ferner die Verwendung einer erfindungsgemäßen elektronischen Schaltungsanordnung, insbesondere eines erfindungsgemäßen Halbleiterrelais, als Trennrelais, Öffnungsrelais oder Wechselrelais. Die Relais können in alle Arten von Schaltungen in Arbeits- und/oder Kraftmaschinen integriert werden. Bevorzugt finden sie in Fahrzeugen, insbesondere Kraftfahrzeugen, Verwendung.

Die Erfindung wird nachfolgend anhand eines Ausführungsbeispiels erläutert, welches für den Fachmann nicht beschränkend zu verstehen ist. Dabei zeigen:
- Fig.1: ein Schaltbild einer elektronischen Schaltungsanordnung gemäß der Erfindung in einer Masseschaltung;
- Fig.2: ein Schaltbild einer elektronischen Schaltungsanordnung gemäß der Erfindung in einer Plusschaltung;
- Fig.3: ein Schaltbild einer elektronischen Schaltungsanordnung gemäß der Erfindung in einer Masseschaltung mit entgegengesetzter Polung;
- Fig.4: ein Schaltbild einer elektronischen Schaltungsanordnung gemäß der Erfindung in einer Plusschaltung mit entgegengesetzter Polung;
- Fig.5: eine Detailansicht eines Ausschnitts der Schaltungsbilder nach Figuren 1 bis 4 einer elektronischen Schaltungsanordnung gemäß der Erfindung mit Überspannungsschutz;
- Fig.6: ein Schaltbild der erfindungsgemäßen Steuerungsschaltung;
- Fig.7: ein Gehäuse des erfindungsgemäßen Halbleiterrelais in Seitenansicht;
- Fig.8: ein Gehäuse des erfindungsgemäßen Halbleiterrelais in Unteransicht;
- Fig.9: das Steckerbild gemäß Figur 7;
- Fig.10: eine alternative Steuerschaltung gemäß der Erfindung;
- Fig.11: ein Detailausschnitt der erfindungsgemäßen Ansteuerungselektronik;
- Fig.12: ein Detailausschnitt des erfindungsgemäßen Spannungserzeugers.

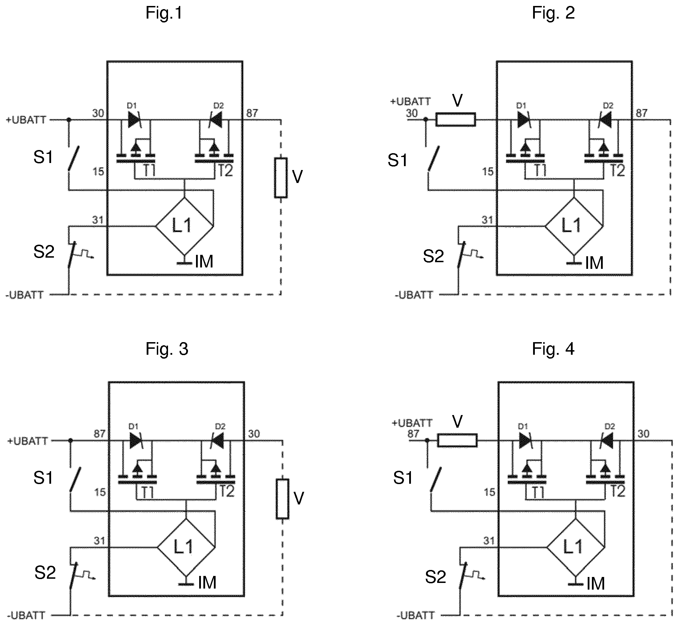

Die Figuren 1 bis 4 zeigen jeweils ein Schaltbild des Halbleiterrelais gemäß der Erfindung mit einer Baugruppe aufweisend eine Steuerungsschaltung L1, die über die Klemmen 15 und 31 an eine Versorgungsspannung angeschlossen ist, beispielsweise einer Batterie. Der positive Pol der Batterie + UBATT ist über einen Eingangsschalter S1 an die Steuerungsschaltung L1 angeschlossen, während der negative Pol - UBATT über einen Schalter S2 an die Klemme 31 der Steuerungsschaltung L1 angeschlossen ist.

Während ein Ausgang der Steuerungsschaltung L1 mit einer internen Masse IM verbunden ist, führt ein zweiter Ausgang zu den Gates der Feldeffekttransistoren T1, T2, die, wie Figuren 1 bis 4 zeigen, als selbstsperrende Power p-Kanal IGFETs, insbesondere Power p-Kanal MOSFETs, ausgebildet sind. Ein dritter Ausgang führt über den Schalter S2 zum negativen Pol - UBATT.

Wie die Figuren 1 und 2 weiter zeigen, sind die Feldeffekttransistoren T1, T2 anti-seriell geschaltet. Die anti-serielle Schaltung ist derart ausgebildet, dass der Drain des ersten Feldeffekttransistors T1 über die Klemme 30 zum positiven Pol + UBATT führt. Die Source des ersten Feldeffekttransistors T1 ist mit der Source des zweiten Feldeffekttransistors T2 leitungstechnisch verbunden. Der Drain des zweiten Feldeffekttransistors T2 führt über die Klemme 87 zum negativen Pol - UBATT.

Die Figuren 3 und 4 zeigen demgegenüber eine entgegengesetzte Polung. Auch hierbei sind die Feldeffekttransistoren T1, T2 anti-seriell geschaltet. Die anti-serielle Schaltung ist derart ausgebildet, dass der Drain des ersten Feldeffekttransistors T1 über die Klemme 87 zum positiven Pol + UBATT führt. Die Source des ersten Feldeffekttransistors T1 ist mit der Source des zweiten Feldeffekttransistors T2 leitungstechnisch verbunden. Der Drain des zweiten Feldeffekttransistors T2 führt über die Klemme 30 zum negativen Pol - UBATT.

Die Figuren 1 bis 4 zeigen außerdem die jeweiligen Bodydioden D1, D2 der Feldeffekttransistoren T1, T2.

Insgesamt ist also ein Lastkreis zwischen den Klemmen 30 und 87 und ein Steuerkreis zwischen den Klemmen 15 und 31 definiert.

Wie Figuren 1 und 3 zeigen, kann ein Verbraucher V gegen Masse geschaltet werden. Ebenso ist es mittels der erfindungsgemäßen Schaltung möglich, einen Verbraucher in Plusschaltung zu schalten, wie es in Figuren 2 und 4 dargestellt ist.

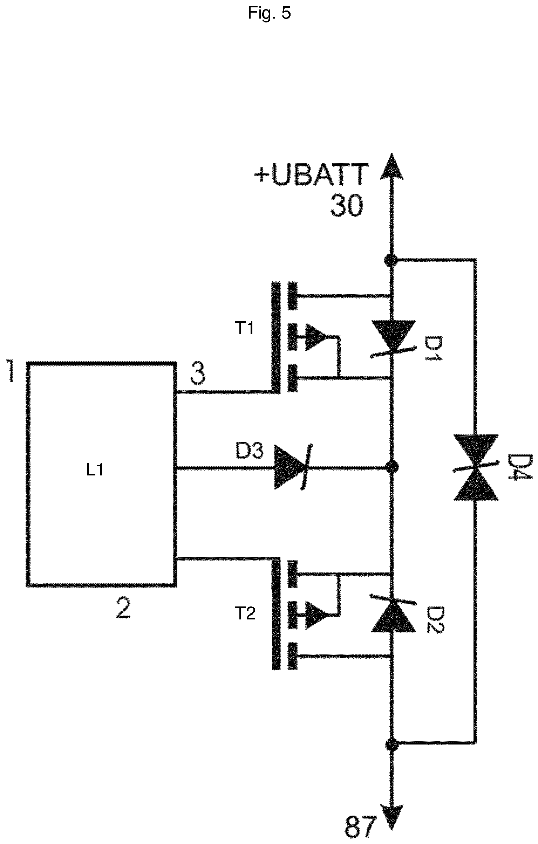

Figur 5 zeigt einen Ausschnitt der Schaltbilder der Figuren 1 bis 4 mit zusätzlich einer Suppressordiode D4 und einer Z-Diode D3 Die Suppressordiode D4 ist parallel zu den Feldeffekttransistoren T1, T2 sowie zu den Dioden D1, D2 geschaltet. Die Z-Diode D3 verbindet die Steuerschaltung L1 mit der Source-Source Verbindung der Feldeffekttransistoren T1, T2. Hierdurch wird ein umfassender Überspannungsschutz realisiert.

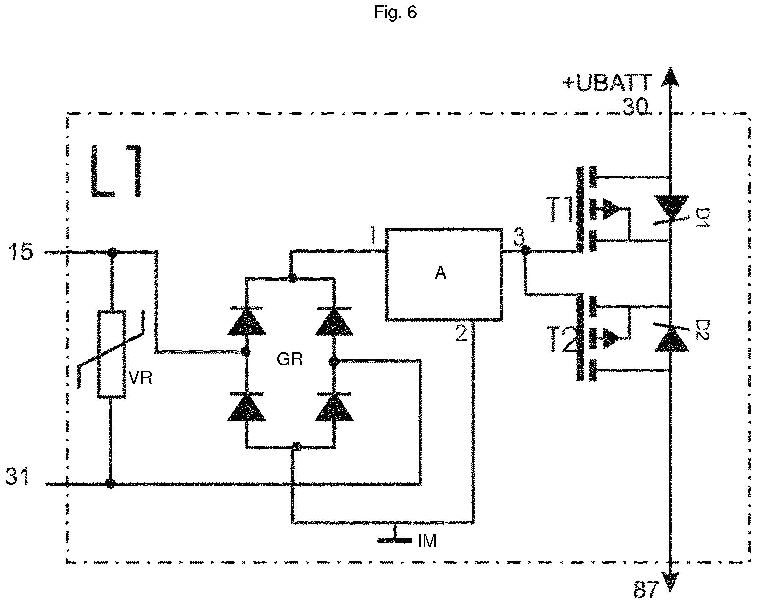

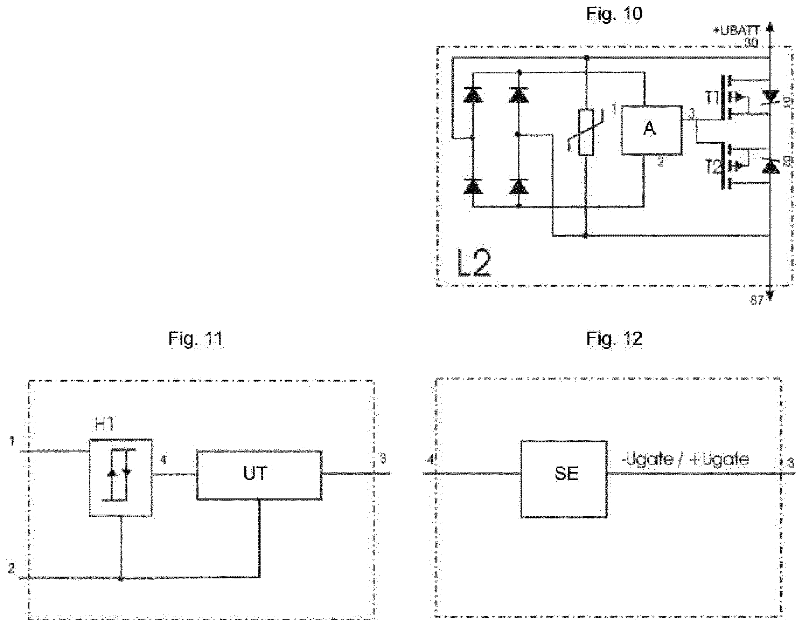

Figur 6 zeigt ein Schaltbild der Steuerungsschaltung L1. Die Steuerungsschaltung weist einen Gleichrichter GR, einen Überspannungsschutz in Form eines Varistors VR und eine Ansteuerungselektronik A auf. Die Ansteuerungselektronik ist zwischen Gleichrichter und den Gates in Reihe geschaltet. Die Ansteuerungselektronik weist eine Hystereseschaltung in Form eines Schmitt-Triggers auf (Figur 11). Die Steuerungsschaltung L1 ist insbesondere dann bevorzugt, wenn das Halbleiterrelais als Trennrelais verwendet wird.

Das Halbleiterrelais ist damit vollständig bidirektional einsetzbar. Ein Verbraucher kann mit dem Halbleiterrelais in Plusschaltung und in Masseschaltung geschaltet werden. Darüber hinaus ist das Halbleiterrelais absolut verpolungssicher ausgebildet.

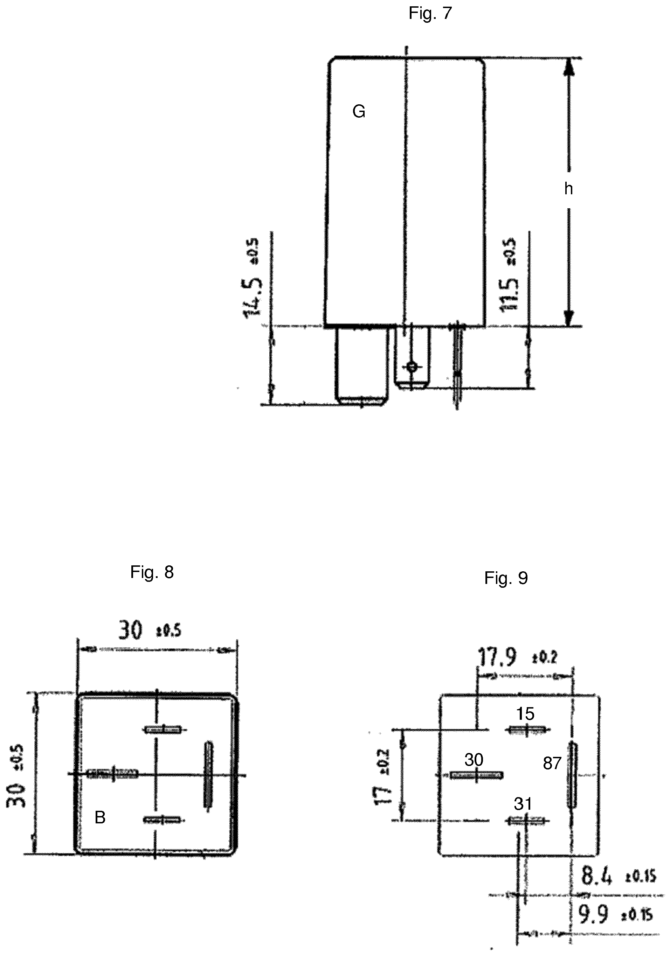

Die Figuren 7 und 8 zeigen ein Gehäuse G (Höhe h = 40 mm) mit einer quadratischen Bodenplatte B, in dem die gesamte Baugruppe mittels einer wärmeleitenden Vergussmasse eingebettet ist. Von der Bodenplatte B stehen flache, genormte Steckkontaktelemente (DIN 46 244 A) ab, deren Steckerbild in Figur 9 gezeigt ist. Dieses Steckerbild ist kompatibel mit genormten elektromagnetischen Steckrelais, so dass ein problemloser Austausch möglich ist.

Die Steckkontaktelemente (Pins) für die beiden Anschlüsse 30 und 87 haben nach DIN 46 244 A die Maße 9,5 x 1,2 mm, diejenigen für die beiden Anschlüsse 15 und 31 die Größe 6,3 x 0,8 mm. Weiter könnten dann auch Ausführungen 2,8x0,8 mm möglich sein.

Es können aber auch andere Gehäusemaße verwendet werden, insbesondere solche mit 30 oder 40mm Höhe oder Bodenplatten mit 6,3mm oder 2,8mm Kontakten.

Figur 10 zeigt eine alternative Steuerungsschaltung L2. Diese ist insbesondere vorteilhaft, wenn das Halbleiterrelais als Öffnungsrelais oder als Wechselrelais verwendet wird.

Hierbei ist der Gleichregler GR nicht an die Klemmen 15 und 31 angeschlossen. Stattdessen ist der Gleichregler an die Klemmen des Versorgungskreises 30 und 87 angeschlossen. Der Gleichregler GR ist ferner mit der Ansteuerungselektronik A in Reihe geschaltet.

Auch die Steuerungsschaltung L2 verfügt über einen Überspannungsschutz in Form eines Varistors. Alternativ kann der Überspannungsschutz auch als Suppressordiode ausgebildet sein.

Die Ansteuerungselektronik A ist im Detail in Figuren 11 und 12 dargestellt. Ihre Ausgestaltung ist in beiden Steuerungsschaltungen L1, L2 gleich. Die Ansteuerungselektronik A weist eine Hystereseschaltung H1 in Form eines Schmitt-Triggers auf. Der Schmitt-Trigger ist in Reihe mit einem Überträger UT leitungstechnisch verbunden.

Die Ausgestaltung des Überträgers UT ist Figur 12 zu entnehmen. Dieser weist einen Spannungserzeuger SE auf, der in Abhängigkeit der verwendeten Feldeffekttransistoren eine positive oder eine negative Steuerungsspannung +Ugate/-Ugate liefert. Sofern wie im vorliegenden Beispiel selbstsperrende p-Kanal IGFETs T1, T2 eingesetzt werden, ist der Spannungserzeuger als Negativspannungsregler ausgebildet. Dies kann insbesondere ein DC-DC-Wandler oder ein Längsregler sein. Der Längsregler kann insbesondere als Spannungsinverter oder mit einem Schaltregler realisiert sein. Sofern alternativ selbstsperrende n-Kanal IGFETs verwendet werden, ist der Spannungserzeuger als wenigstens eine Ladungspumpe ausgebildet.

### Bezugszeichenliste

- 15: Klemme
- 30: Klemme
- 31: Klemme
- 87: Klemme
- A: Ansteuerungselektronik
- B: Bodenplatte
- D1: Bodydiode
- D2: Bodydiode
- D3: Z-Diode
- D4: Suppressordiode
- G: Gehäuse
- GR: Gleichrichter
- h: Höhe des Gehäuses
- IM: interne Masse
- L1: Steuerungsschaltung
- L2: Steuerungsschaltung
- S1: Eingangsschalter
- S2: Schutzschalter
- SE: Spannungserzeuger
- T1: p-Kanal IGFET
- T2: p-Kanal IGFET
- UT: Überträger
- V: Verbraucher
- VR: Varistor

## Patentansprüche

1. Elektronische Schaltungsanordnung, insbesondere Halbleiterrelais, zur bidirektionalen elektronischen Leistungsschaltung, welche an einen Verbraucher und an eine elektrische Spannungsquelle anschließbar ist, aufweisend zwei Feldeffekttransistoren und eine Steuerungsschaltung, wobei die Steuerungsschaltung mit dem jeweiligen Gateanschluss der Feldeffekttransistoren leitungstechnisch verbunden ist, **dadurch gekennzeichnet, dass** die Feldeffekttransistoren anti-seriell geschaltet sind.

2. Elektronische Schaltungsanordnung nach Anspruch 1, **dadurch gekennzeichnet, dass** die Feldeffekttransistoren durch p-Kanal IGFETs gebildet sind.

3. Elektronische Schaltungsanordnung nach Anspruch 2, **dadurch gekennzeichnet, dass** die p-Kanal IGFETs selbstsperrend sind.

4. Elektronische Schaltungsanordnung nach Anspruch 3, **dadurch gekennzeichnet, dass** die Feldeffekttransistoren durch Power-IGFETs gebildet sind.

5. Elektronische Schaltungsanordnung nach einem der Ansprüche 1 bis 3, **dadurch gekennzeichnet, dass** die Sourceanschlüsse der Feldeffekttransistoren leitungstechnisch miteinander verbunden sind.

6. Elektronische Schaltungsanordnung nach einem der Ansprüche 1 bis 5, **dadurch gekennzeichnet, dass** die Steuerungsschaltung einen Gleichrichter aufweist.

7. Elektronische Schaltungsanordnung nach einem der Ansprüche 1 bis 6, **dadurch gekennzeichnet, dass** die Steuerungsschaltung einen Schmitt-Trigger aufweist.

8. Elektronische Schaltungsanordnung nach einem der Ansprüche 1 bis 7, **dadurch gekennzeichnet, dass** die Steuerungsschaltung einen Negativspannungsregler oder eine Ladungspumpe aufweist.

9. Elektronische Schaltungsanordnung nach einem der Ansprüche 1 bis 8, **dadurch gekennzeichnet, dass** zur Leistungsanpassung weitere Feldeffekttransistoren parallel zu den ersten beiden Feldeffekttransistoren geschaltet werden können.

10. Verwendung einer elektronischen Schaltungsanordnung, insbesondere eines Halbleiterrelais, gemäß einem der Ansprüche 1 bis 9 als Trennrelais, Öffnungsrelais oder Wechselrelais.
